Europäisches Patentamt

European Patent Office

Office européen des brevets

(11) Veröffentlichungsnummer: **0 309 788**
**A1**

(12) **EUROPÄISCHE PATENTANMELDUNG**

(21) Anmeldenummer: 88114632.8

(51) Int. Cl.⁴: **H01L 21/76**

(22) Anmeldetag: 07.09.88

(30) Priorität: 30.09.87 DE 3733020
29.07.88 DE 3825894

(43) Veröffentlichungstag der Anmeldung:
05.04.89 Patentblatt 89/14

(84) Benannte Vertragsstaaten:
**DE FR GB IT**

(71) Anmelder: **Siemens Aktiengesellschaft Berlin
und München**
**Wittelsbacherplatz 2**
**D-8000 München 2(DE)**

(72) Erfinder: **Reichert, Hansjörg, Dr., Dipl.-Phys.**
**Weissenseestrasse 83**
**D-8000 München 90(DE)**
Erfinder: **Scharf, Ludwig, Dipl.-Phys.**
**Montgelasstrasse 33**
**D-8000 München 80(DE)**
Erfinder: **Goedecke, Heidemarie**
**Daphnestrasse 17**
**D-8000 München 81(DE)**
Erfinder: **Weidlich, Herbert. Dr.**
**Bajuwarenstrasse 13**
**D-8021 Sauerlach(DE)**

(54) **Verfahren zur Erzeugung eines versenkten Oxids.**

(57) Ein Verfahren zur Erzeugung eines versenkten
Oxids soll die Herstellung großer Anschluß-Pads bei
kleiner Kapazität dieser Anschluß-Pads bei gleichzeitig dickem Oxid auf der Halbleiteroberfläche bei
gleichzeitig guter Abbildung von Feinstrukturen auf
der Oberfläche eines Transistors insbesondere auch
bei Kontaktbelichtung ermöglichen. Mit einer Schutzschicht (2) wird ein Bereich (S1) einer Halbleiteroberfläche (1) abgedeckt. Die nicht mit der Schutzschicht (2) abgedeckte Fläche der Halbleiteroberfläche (1) wird geätzt. Dann wird ein Oxid (3) der
gewünschten Dicke (b) abgeschieden. Mit einem
zweiten Phototechnik-Schritt wird das abgeschiedene Oxid (3) mit einer Struktur (S2) geätzt. Es folgt
eine thermische Oxidation mit Aufwachsen einer
thermischen Oxidschicht (4), deren Dicke (c) klein ist
im Vergleich zur Dicke (b) der abgeschiedenen
Oxidschicht (3). Die thermische Oxidschicht (4) wird
mit der gewünschten Geometrie strukturiert.

FIG 6

## Verfahren zur Erzeugung eines versenkten Oxids

Die Erfindung betrifft ein Verfahren zur Erzeugung eines versenkten Oxids.

Bei Bipolar-Hochfrequenz-Transistoren aus Silizium wirkt sich die Kapazität der Anschluß-Pads störend auf das Hochfrequenz-Verhalten der Bipolar-Transistoren aus. Um die Kapazität der Anschluß-Pads zu verkleinern, können entweder die Anschluß-Pads klein gehalten werden, was eine automatische Verarbeitung der Bipolar-Hochfrequenz-Transistor-Chips bei der Montage dieser Chips in das Gehäuse dieser Bipolar-Hochfrequenz-Transistoren verhindert, oder das Oxid, das auf der Halbleiteroberfläche der Bipolar-Transistoren zwischen einem Anschluß-Pad beispielsweise eines Emitters bzw. einer Basis und dem Kollektor liegt, kann dick gemacht werden, wodurch aber insbesondere bei Kontaktbelichtung zur Strukturierung des Oxids auf der Halbleiteroberfläche eine Abbildung von Feinstrukturen unmöglich ist.

Bisher wurden bei Bipolar-Hochfrequenz-Transistoren aus Silizium hauptsächlich kleine Anschluß-Pads hergestellt, da eine Verdickung des Oxids auf der Halbleiteroberfläche eine Vertiefung der Basis-Wanne mit sich bringt, was insbesondere bei Kontaktbelichtungen zur Strukturierung des Oxids stört. Um dieser Störung abzuhelfen, könnte das Oxid auf der Halbleiteroberfläche versenkt werden. Bisher zur Versenkung des Oxids verwendete Verfahren haben entweder negativen Einfluß auf andere Hochfrequenz-Parameter. z. B. die LOCOS-Technologie. oder sind technologisch sehr aufwendig. z. B. die Erzeugung eines Oxids auf der Halbleiteroberfläche aus porösem Silizium.

Der vorliegenden Erfindung liegt die Aufgabe zugrunde, ein Verfahren der eingangs genannten Art anzugeben, das die Herstellung großer Anschluß(Bond)-Pads bei kleiner Kapazität dieser Anschluß- Pads bei gleichzeitig dickem Oxid auf der Halbleiteroberfläche bei gleichzeitig guter Abbildung von Feinstrukturen auf der Oberfläche des Transistors insbesondere auch bei Kontaktbelichtung ermöglicht.

Diese Aufgabe wird durch ein Verfharen nach einem der Patentansprüche 1 bis 3 gelöst.

Vorteile und Ausgestaltungen der Erfindung sind in der Beschreibung und der Zeichnung dargestellt.

Die Oberfläche des auf der Halbleiteroberfläche abgeschiedenen Oxids kann über oder unter der Null-Linie sich befinden. Dies bedeutet, daß die Oberfläche des auf der Halbleiteroberfläche abgeschiedenen Oxids über die Oberkante des nicht-oxidierten Bereichs (S3) hinausragen kann oder tiefer liegen kann als die Oberkante des nicht-oxidierten Bereichs (S3).

Ein auf der Halbleiteroberfläche abgeschiedenes Oxid kann unter die Null-Linie versenkt sein. Ohne zusätzliche Maßnahmen kann im Gegensatz dazu ein LOCOS-Oxid nicht unter die Null-Linie versenkt sein. Demzufolge kann ein LOCOS-Oxid nicht soweit versenkt werden, daß insbesondere bei Kontaktbelichtung eine Abbildung von Feinstrukturen möglich ist.

Die Erfindung wird anhand der Zeichnung näher erläutert.

FIG 1 bis 6 beschreiben ein einfaches Verfahren zur Versenkung eines dicken Oxids.

FIG 7 erläutert in der Draufsicht auf die Oberfläche des Halbleiter-Transistors die verwendeten Strukturen.

FIG 8 bis 12 beschreiben ein verbessertes Verfahren zur Versenkung eines dicken Oxids.

FIG 13 und 14 beschreiben ein weiteres verbessertes Verfahren.

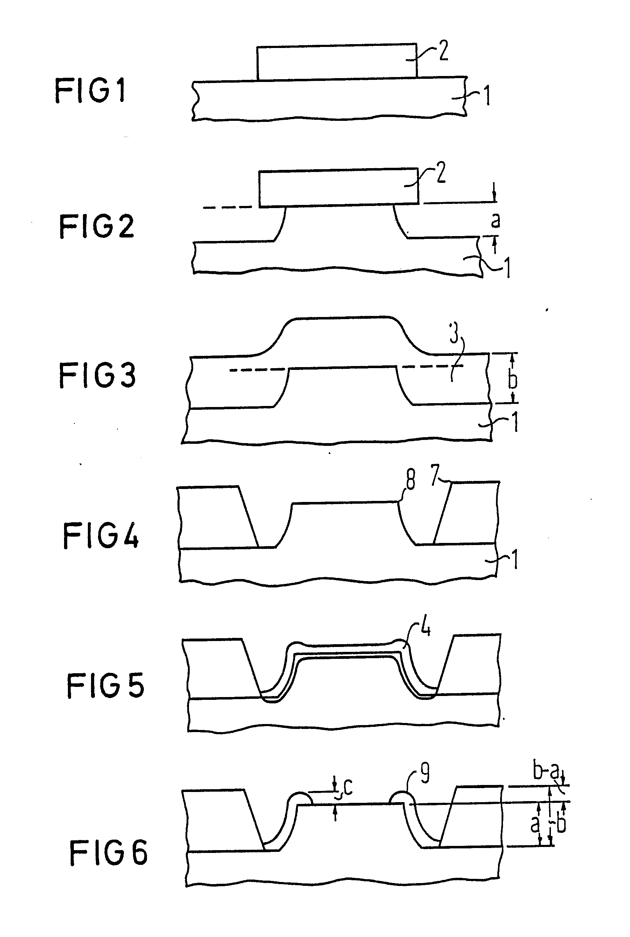

Die FIG 1 bis 6 erläutern ein einfaches Verfahren zur Versenkung eines dicken Oxids, so daß mit großen Kontakt-Anschluß-Pads gearbeitet werden kann.

Gemäß FIG 1 wird mit einer Schutzschicht 2 ein bestimmter Bereich S1 in einer aus Silizium bestehenden Halbleiteroberfläche 1 abgedeckt, der größer als der später gewollte Basisbereich S3 ist. Die Schutzschicht 2 kann beispielsweise aus Nitrid bestehen.

Die von der Schutzschicht 2 nicht geschützte Fläche der Halbleiteroberfläche 1 wird geätzt, bis eine Vertiefung der Tiefe a entsteht, welche Tiefe a fast die Höhe b der später gewünschten Oxidschicht 3 hat (die Tiefe a soll kleiner als die Dicke der später gewünschten Oxidschicht 3 sein) (FIG2).

Gemäß FIG 3 wird anschließend ein Oxid 3 der gewünschten Dicke b abgeschieden. Dabei ist die Dicke b etwas größer als die Tiefe a. Das Oxid 3 kann insbesondere ein CVD-Oxid sein.

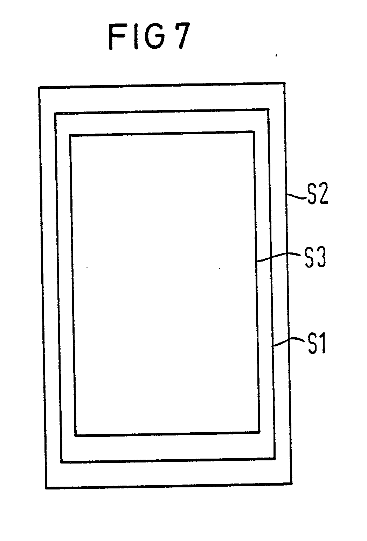

Gemäß FIG 4 wird mit einem zweiten Phototechnik-Schritt das abgeschiedene Oxid 3 mit einer Struktur S2 größer als der Bereich S1 geätzt. Aufgrund der sich bei FIG 2 ergebenden Unterätzung unter Schutzschicht 2 und der sich bei FIG 4 ergebenden Schrägätzung besitzt die Oberkante 7 des gemäß FIG 4 verbleibenden Oxids von der Oberkante 8 der Halbleiteroberfläche einen Abstand, der etwa der Dicke b des abgeschiedenen Oxids 3 entspricht.

Gemäß FIG 5 erfolgt eine thermische Oxidation mit Aufwachsen einer dünner thermischen Oxidschicht 4 der Dicke c. Die Dicke c der thermischen Oxidschicht 4 ist sehr viel kleiner als die Dicke b des abgeschiedenen Oxids 3.

Gemäß FIG 6 wird das thermische Oxid 4 mit der endgültigen Basisgeometrie S3 strukturiert. Die dabei erhaltene Wannentiefe der Basiswanne ist gleich der Dicke c des thermischen Oxids 4 bei geeigneter Wahl von Tiefe a und Dicke c. Wenn die Dicke c des thermischen Oxids 4 größer ist als die Differenz aus Dicke b des abgeschiedenen Oxids 3 und Tiefe a der gemäß FIG 2 erzeugten Vertiefung, ist die in FIG 6 gezeigte Oberkante 9 des thermischen Oxids 4 der höchste Punkt der gesamten Anordnung nach den FIG 5 bis 6. Wenn die Oberkante 9 des thermischen Oxids 4 der höchste Punkt ist, ist insbesondere auch bei einer Kontaktbelichtung eine Abbildung von Feinstrukturen möglich. Dabei kann die Höhendifferenz zwischen der Oberkante 9 des thermischen Oxids 4 und der Oberkante 7 des abgeschiedenen Oxids 3 klein sein. Obwohl die Dicke c des thermischen Oxids 4 klein ist, kann kein Kurzschluß im Bereich des thermischen Oxids 4 erfolgen, und wegen der geringen Breite des vom thermischen Oxid 4 bedeckten Bereichs ist dennoch keine große Kapazität vorhanden. Daher ermöglicht ein Verfahren nach der Erfindung große Bond-Pads bei gleichzeitig kleiner Kapazität und bei gleichzeitig dickem Oxid. Ein Verfahren nach der Erfindung kann selbst-justierend erfolgen.

FIG 7 erläutert in der Draufsicht auf die Oberfläche eines Bipolar-Transistors ein Verfahren nach der Erfindung. Gemäß FIG 1 wird mit einer Schutzschicht 2 ein Bereich S1 abgedeckt werden. Gemäß FIG 4 wird mit einem zweiten Photo-Technikschritt das abgeschiedene Oxid 3 mit einer Struktur S2 geätzt, die größer als die Struktur S1 ist. Gemäß FIG 6 wird das thermische Oxid 4 mit der endgültigen Basisgeometrie (Struktur S3) strukturiert.

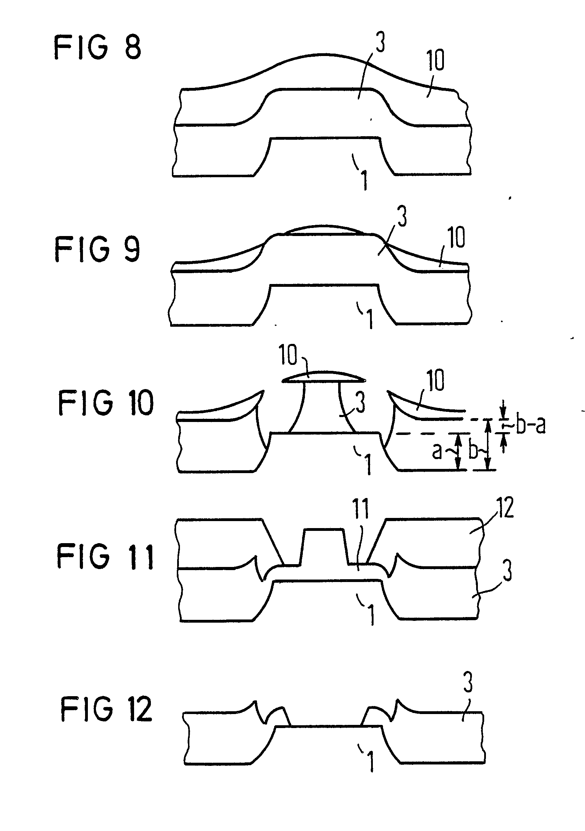

Anhand der FIG 8 bis 14 werden zwei verbesserte Verfahren zur Versenkung eines dicken Oxids 3 erläutert. Für diese beiden verbesserten Verfahren werden zunächst die Verfahrensschritte gemäß FIG 1 bis 3 ausgeführt. Verfahrens-Ausführungen nach den FIG 8 bis 14 benutzen einen selbstjustierenden Prozeß, um den in FIG 6 sichtbaren Graben in der Oberflächentopologie möglichst klein zu halten. Über diesen Graben, der in FIG 6 sichtbar ist, müssen nämlich die Anschlußmetallisierungen, z.B. bei Hochfrequenztransistoren, hinweg geführt werden. Je tiefer der Graben in FIG 6 ist, desto größer ist das Risiko von Dünnstellen in der Anschlußmetallisierung. Außerdem verursachen die Anschlußmetallisierungen im Bereich des dünnen Oxids 4 erhöhte Parasitärkapazitäten. Daher bringt es einen großen Gewinn, die Bereiche des dünnen Oxids 4 möglichst schmal zu gestalten.

Aufbauend auf den Verfahrensschritten gemäß FIG 1 bis 3 ergeben sich bei einem ersten verbesserten Verfahren folgende weitere Verfahrensschritte:

Gemäß FIG 8 wird auf die Oberfläche des Oxids 3 eine Lackschicht 10 aufgebracht. Diese Lackschicht 10 wird durch Erwärmung (Erwärmung je nach Lacksorte) zum Fließen gebracht. Dabei entsteht eine geglättete Lackoberfläche wie in FIG 8 gezeigt. An den Kanten des Mesa-Berges 1 ist die Lackschicht 10 dünner als oberhalb von ebenen Flächen der Halbleiteroberfläche.

Daher legt eine gerichtete Rückätzung der Lackschicht 10 zuerst die Kanten des Mesa-Berges 1 frei (FIG 9). Diese gerichtete Rückätzung der Lackschicht 10 kann mit Sauerstoff-RIE erfolgen.

Eine anschließende Ätzung des Oxids 3 kann soweit geführt werden, daß die Kanten der Silizium-Mesa 1 gerade frei gelegt werden, ohne daß die Flanken der Silizium-Mesa 1 dabei voll entblößt sind (FIG 10). Im Inneren des Bereichs der Silizium-Mesa 1 verbleibt dabei ein Teil des Oxids 3 stehen und muß durch einen weiteren Fotolithographie-Schritt entfernt werden.

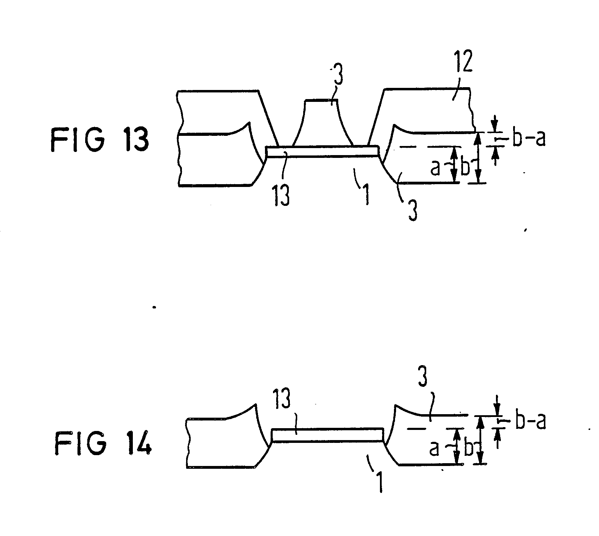

Für diesen weiteren Fotolithographie-Schritt wird die Lackschicht 10 völlig entfernt. Sodann läßt man eine dünne Oxidschicht 11 aufwachsen. Schließlich wird eine weitere Lackschicht 12 aufgebracht. Diese Lackschicht 12 wird bei dem weiteren Fotolithographie-Schritt strukturiert. Die Genauigkeit der Justierung bei diesem weiterem Fotolithographie-Schritt muß so groß sein, daß die Kontur des strukturierten Fotolacks 12 (FIG 11 und 13) in den gemäß Fig 10 freigeätzten Bereich hinein trifft. Die Breite dieses gemäß FIG 10 freigeätzten Bereiches um die Silizium-Mesa 1 herum entspricht etwa der zweifachen Dicke des Oxids 3, nämlich einer Dicke von 2b.

Ausgehend von dem Verfahrensschritt gemäß FIG 10 können dabei zwei verschiedene Wege beschritten werden. Der erste dieser beiden Schritte ist anhand der FIG 11 und 12 erläutert, der zweite dieser beiden Schritte ist anhand der FIG 13 und 14 näher beschrieben.

Gemäß den Verfahrensschritten nach den FIG 11 und 12 wird zunächst der Lack 10 vollständig abgelöst und das verbliebene Halbleiterbauteil gereinigt. Sodann wird das verbliebene Halbleiterbauteil nochmals mit einem dünnen Oxid 11 abgedeckt. In diesem dünnen Oxid 11 wird dann die Kontur der Basis mit Hilfe der weiteren justierten Fotolithographie (Fotolack 12) definiert (FIG 11) und freigeätzt (FIG 12).

Verfahrensschritte gemäß FIG 11 und 12 sind vorzugsweise dann zu verwenden, wenn erst nach Ausführung der Verfahrensschritte gemäß FIG 11 und 12 die Basisdotierung durch dasselbe Fenster mittels Implantation oder Diffusion eingebracht werden soll.

Wenn die Basisdotierung schon früher in die Halbleiteroberfläche 1 eingebracht worden ist, sind, ausgehend von FIG 10, Verfahrensschritte gemäß FIG 13 und 14 den Verfahrensschritten gemäß FIG 11 und 12 vorzuziehen.

Bei den Verfahrensschritten gemäß FIG 13 und 14 wird auf ein weiteres Oxid 11 verzichtet. Nach Entfernen des Fotolacks 10 (ausgehend von FIG 10) wird unmittelbar eine weitere Lackschicht 12 aufgebracht. Die justierte Strukturierung dieser Fotolackschicht 12 erfolgt entsprechend zu der justierten Strukturierung der Fotolackschicht 12 gemäß FIG 11. Im Inneren des Mesa-Bereiches bleibt dabei ebenfalls ein Teil des Oxids 3 stehen. Dieser im Inneren des Mesa-Bereichs verbleibende Teil des Oxids 3 wird sodann weggeätzt. Die Basisoberfläche inklusive der am Rand des Mesa-Bereichs austretenden pn-Übergänge 13 bestehen dann aus unbedecktem Silizium und müssen anschließend daran mit einem Dielektrikum ausreichender Qualität abgedeckt werden. Der Vorteil der Verfahrensschritte gemäß FIG 13 und 14 besteht darin, daß die Kontur der gemäß FIG 13 durchgeführten Fotolithographie nach dem Ablösen des Lacks 12 (FIG 14) verschwindet.

**Ansprüche**

1. Verfahren zur Erzeugung eines versenkten Oxids, bestehend aus folgenden Schritten:

a) Mit einer Schutzschicht (2) wird ein Bereich (S1) einer Halbleiteroberfläche (1) abgedeckt, der größer ist als der später gewollte nicht-oxidierte Bereich (S3);

b) die nicht mit der Schutzschicht (2) abgedeckte Fläche der Halbleiteroberfläche (1) wird geätzt, bis eine Vertiefung entsteht, die fast die Höhe (b) der später gewünschten Oxidschicht (3) hat;

c) dann wird ein Oxid (3) der gewünschten Dicke (b) abgeschieden;

d) mit einem zweiten Phototechnik-Schritt wird das abgeschiedene Oxid (3) mit einer Struktur (S2) geätzt, die den im Verfahrensschritt (a) erzeugten Schutzschichtsbereich (S1) umfaßt und größer als dieser Schutzschichtsbereich (S1) ist;

e) es folgt eine thermische Oxidation mit Aufwachsen einer thermischen Oxidschicht (4), deren Dicke (c) klein ist im Vergleich zur Dicke (b) der abgeschiedenen Oxidschicht (3);

f) die thermische Oxidschicht (4) wird mit der endgültig gewünschten Geometrie des gewollten nicht-oxidierten Bereichs (S3) strukturiert.

2. Verfahren zur Erzeugung eines versenkten Oxids, bestehend aus folgenden Schritten:

a) Mit einer Schutzschicht (2) wird ein Bereich (S1) einer Halbleiteroberfläche (1) abgedeckt, der größer ist als der später gewollte nicht-oxidierte Bereich (S3);

b) die nicht mit der Schutzschicht (2) abgedeckte Fläche der Halbleiteroberfläche (1) wird geätzt, bis eine Vertiefung entsteht, die fast die Höhe (b) der später gewünschten Oxidschicht (3) hat;

c) dann wird ein Oxid (3) der gewünschten Dicke (b) abgeschieden;

d) auf das Oxid (3) wird eine Lackschicht (10) aufgebracht; diese Lackschicht (10) wird zum Fließen gebracht;

e) die Lackschicht (10) wird rückgeätzt, bis die Mesa-Kanten des Oxids (3) freiliegen;

f) anschließend wird das Oxid (3) soweit geätzt, daß die Mesa-Kanten (8) der Silizium-Mesa gerade freigelegt werden;

g) nach Ablösen der Lackschicht (10) wird das verbliebene Halbleiter-Bauteil nochmals mit einem dünnen Oxid (11) abgedeckt;

h) das dünne Oxid (11) wird mit der endgültig gewünschten Geometrie des gewollten nicht-oxidierten Bereichs strukturiert.

3. Verfahren zur Erzeugung eines versenkten Oxids, bestehend aus folgenden Schritten:

a) Mit einer Schutzschicht (2) wird ein Bereich (S1) einer Halbleiteroberfläche (1) abgedeckt, der größer ist als der später gewollte nicht-oxidierte Bereich (S3);

b) die nicht mit der Schutzschicht (2) abgedeckte Fläche der Halbleiteroberfläche (1) wird geätzt, bis eine Vertiefung entsteht, die fast die Höhe (b) der später gewünschten Oxidschicht (3) hat;

c) dann wird ein Oxid (3) der gewünschten Dicke (b) abgeschieden;

d) auf das Oxid (3) wird eine Lackschicht (10) aufgebracht; diese Lackschicht (10) wird zum Fließen gebracht;

e) die Lackschicht (10) wird rückgeätzt, bis die Mesa-Kanten des Oxids (3) freiliegen;

f) anschließend wird das Oxid (3) soweit geätzt, daß die Mesa-Kanten (8) der Silizium-Mesa gerade freigelegt werden;

g) nach Ablösen der Lackschicht (10) wird mittels eines justierten Lithographie-Schritts der Innenbereich der Halbleiter-Mesa freigelegt und der dort verbliebene Teil des Oxids (3) abgeätzt.

FIG 1

FIG 2

FIG 3

FIG 4

FIG 5

FIG 6

FIG 7

FIG 8

FIG 9

FIG 10

FIG 11

FIG 12

FIG 13

FIG 14

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EXTENDED ABSTRACTS OF THE 15th CONFERENCE ON SOLID STATE DEVICES AND MATERIALS, 1983, "Supplements 1983", Seiten 249-252, Tokyo, JP; T. MORIMOTO et al.: "MOS device characteristics by perfect planar technology" * Seite 249, Spalte 1, Absatz 1; Figur 1 * | 1 | H 01 L 21/76 |
| A | GB-A-2 088 627 (HITACHI) * Figuren 1,2 * | 1 | |
| A | FR-A-2 308 204 (IBM) * Figur 1 * | 1 | |
| A | EP-A-0 095 328 (TOSHIBA) * Figuren 3A-3D * | | |

**RECHERCHIERTE SACHGEBIETE (Int. Cl.4)**

H 01 L

Der vorliegende Recherchenbericht wurde für alle Patentansprüche erstellt

| Recherchenort | Abschlußdatum der Recherche | Prüfer |
|---|---|---|
| DEN HAAG | 21-11-1988 | VANCRAEYNEST F.H. |